# EUROPÄISCHE PATENTSCHRIFT

(11) **EP 0 597 052 B1**
(45) Veröffentlichungstag und Bekanntmachung des Hinweises auf die Patenterteilung: **17.04.1996**
(21) Anmeldenummer: 93909739.0
(22) Anmeldetag: 21.05.1993
(51) Int. Cl.: H01L 21/00

(54) **TRANSPORTROBOTER FÜR EINE BEARBEITUNGS- BZW. BEHANDLUNGSLINIE FÜR SYSTEMTRÄGER**
TRANSPORT ROBOT FOR A MACHINING OR PROCESSING LINE FOR LEAD FRAMES
ROBOT DE TRANSPORT POUR UNE LIGNE DE TRAITEMENT OU DE MANUTENTION POUR DES CADRES DE MONTAGE

(30) Priorität: 03.06.1992 CH 1785/92
(43) Veröffentlichungstag der Anmeldung: 18.05.1994
(73) Patentinhaber: ESEC SA, CH-6330 Cham/Steinhausen (CH)
(72) Erfinder: MEISSER, Claudio, CH-6330 Cham (CH); KOSTER, Christof, CH-6319 Allenwinden (CH); KONRAD, Marcel, CH-6017 Ruswil (CH)
(74) Vertreter: EGLI-EUROPEAN PATENT ATTORNEYS
(86) Internationale Anmeldenummer: CH9300130
(87) Internationale Veröffentlichungsnummer: WO9324953

(56) Entgegenhaltungen:
- EP-A- 0 304 370
- EP-A- 0 412 945
- SOLID STATE TECHNOLOGY Bd. 32, Nr. 5, Mai 1989, WASHINGTON US Seiten 51 - 54 JACOB SCHERER 'Programmable Handling Systems on Assembly Equipment.'

## Beschreibung

Die Erfindung betrifft einen Transportroboter zum Transport eines im wesentlichen quaderförmigen Magazins für mit elektronischen Bauelementen (sogenannten Chips) bestückte systemträger (sogenannte Leadframes) in einer Linie von Maschinen bzw. Einrichtungen zur automatischen Bearbeitung bzw. Behandlung dieser elektronischen Bauelemente, wobei das Magazin im wesentlichen aus zwei einander parallelen und im Abstand voneinander gehaltenen Wänden besteht und mit mindestens einem in Fächern oder Nuten seiner Wände eingesetzten Systemträgern bestückt ist, und wobei der Transportroboter mit einer Greifeinrichtung zum automatischen Fassen und Loslassen des Magazins versehen ist.

Bei der Verarbeitung von aus Halbleiterscheiben (sogenannten Wafers) herausgetrennten einzelnen elektronischen Bauelementen (sogenannten Chips) zu einem gebrauchsfertigen Zustand, der ihren industriellen Einsatz in elektronischen Schaltungen erlaubt, besteht seit langem ein Bedarf für Qualitätssteigerung und Prozess-Optimierung. Dieser Bedarf führte dazu, ganze Linien von Maschinen bzw. Einrichtungen zur automatischen Bearbeitung bzw. Behandlung dieser elektronischen Bauelemente aufzustellen und einzusetzen. Dabei werden die zunächst auf Systemträger (sogenannte Leadframes) angebrachten elektronischen Bauelemente (sogenannten Chips) auf diesen Systemträgern weiterverarbeitet.

In derartigen Linien werden die Systemträger von Station zu Station transportiert. Beispielsweise sind eine oder mehrere Einrichtungen (sogenannte Die Bonder) zur Befestigung der elektronischen Bauelemente auf dem Systemträger, eine oder mehrere Einrichtungen zur Aushärtung von Klebstoffen (sogenannte Curing-öfen) und eine oder mehrere Einrichtungen zur Drahtkontaktierung (sogenannte Wire Bonder) in einer Linie angeordnet, wobei der Transport der Systemträger in Magazinen der eingangs angegebenen Art erfolgt. In solchen Magazinen sind die Systemträger seitlich eingeschoben, jedoch in dieser Einschubrichtung nicht befestigt.

In Abhängigkeit der bearbeiteten Systemträger müssen in einer solchen Linie Magazine unterschiedlichster Breite, Länge und Höhe gehandhabt werden können. Der automatische Transport der Magazine wird durch einen Transportroboter bewerkstelligt, welcher die Magazine von Station zu Station transportiert.

Transportroboter dieser Art sind in Solid State Technology, May 1989, Seiten 51-54 und in EP-A-0 412 945 beschrieben.

Bestimmte bisherige Transportroboter weisen eine Greifeinrichtung auf, mit der ein Magazin oben und unten von entsprechenden Greifern gefasst wird. Dies hat den erheblichen Nachteil, dass die Systemträger aus dem Magazin seitlich herausgleiten, sobald der Transportroboter mit Schwung bzw. ansehnlicher Beschleunigung eine horizontale Bewegung parallel zur Einschubrichtung der Systemträger ausführt.

Ein weiterer Nachteil ist, dass die Magazine zum Fassen und Greifen angehoben werden müssen oder aber sich über Ausnehmungen befinden, damit der untere Greifer unter das Magazin greifen kann.

Ferner sind es nicht dieselben Kanten eines Magazins, die an den Bearbeitungs- bzw. Behandlungsstationen in Ladeposition und Entladeposition des Magazins als Referenzkante für den Transportroboter wirken, so dass die Greifer bisheriger Transportroboter das Magazin an einer anderen Stelle beim Wiederaufnehmen angreifen als beim Abladen. Hierdurch addieren sich die Positionierfehler des Transportroboters, und das Magazin wird bei der nächsten Bearbeitungs- bzw. Behandlungsstation an eine verschobene Position versetzt, so dass schliesslich der Transport des Magazins gefährdet ist, vor allem bei dem heute verwendeten System des Riementransportes des Magazins an bzw. in den Bearbeitungs- bzw. Behandlungsstationen selbst.

Aufgabe der vorliegenden Erfindung ist es, eine Bearbeitungslinie der obengenannten Art so zu verbessern, dass ein gesicherter Transport der Magazine bzw. der Systemträger in den Magazinen möglich ist, dass sich Positionierfehler von Transportrobotern nicht addieren, und dass unterschiedlichsten Magazinen Rechnung getragen werden kann.

Zur Lösung dieser Aufgabe ist ein Transportroboter der eingangs angegebenen Art dadurch gekennzeichnet, dass die Greifeinrichtung zwei Klemmbacken aufweist, die an je einer Seitenkante einer Wand des Magazins anliegen und zusammen diese Wand einklemmen, wenn das Magazin von der Greifeinrichtung gefasst ist, wobei in Richtung orthogonal zu dieser eingeklemmten Wand eine Breite der Klemmbacken grösser ist als die Dicke dieser Wand.

Dies bedeutet, dass die Klemmbacken beiderseits in die lichte Weite des Magazins einragen, so dass die Systemträger seitlich nicht mehr aus dem Magazin herausgleiten können.

Dies bedeutet auch, dass das Magazin nicht mehr von oben und unten, sondern von der Seite her gefasst wird. Damit entfällt ein Anheben des Magazins, um einen Greifer unter das Magazin zu führen. Das Magazin kann jetzt auf einer entsprechenden Transportfläche der Bearbeitungs- bzw. Behandlungsstation mittels des Riementransports gefördert werden und beispielsweise wieder in eine Entladeposition gebracht werden, die in etwa der Ladeposition entspricht.

Vorzugsweise liegen dabei die einander zugewandten Seiten der beiden Klemmbacken im wesentlichen in einander parallelen Ebenen, welche ihrerseits orthogonal zur eingeklemmten Wand liegen. Diese Anordnung ist optimal an die im wesentlichen quaderförmigen Ausbildung des Magazins angepasst.

Bei dem bereits erwähnten System des Riementransportes des Magazins in den Bearbeitungs- bzw. Behandlungsstationen wird das Magazin in seiner Lade- oder Entladeposition durch den bzw. die Riemen, besser gesagt durch die Reibung des Magazins am bzw. an den laufenden Riemen, gegen eine Stufe gedrückt, die höher als die Bodenebene des Magazins liegt und dadurch als Anschlag für das Magazin wirkt. Somit wird die Position des Magazins durch das Anliegen des Magazins an der Stufe gut definiert. Dabei kann jedoch die Greifeinrichtung des Transportroboters nur über die Stufe hinweg zum Magazin gelangen, was bedeutet, dass die Greifeinrichtung relativ hoch an das Magazin heranfahren muss mit der Folge, dass die im Magazin untersten Systemträger unter diesen Umständen nicht am seitlichen Herausgleiten gehindert werden.

Übrigens müsste die Greifeinrichtung des Transportroboters auch ohne diese Stufe relativ hoch an das Magazin heranfahren, um ein Schleifen des Mechanismus der Greifeinrichtung auf der Transportfläche der Bearbeitungs- bzw. Behandlungsstation zu vermeiden, wiederum mit der Folge, dass die im Magazin untersten Systemträger unter diesen Umständen nicht am seitlichen Herausgleiten gehindert werden.

Zur Abhilfe ist vorzugsweise an einem unteren Rand jeder Klemmbacke eine Nase angeformt, deren der anderen Nase zugewandte Seite in derselben Ebene liegt wie die entsprechende Ebene der Klemmbacke selbst, während vorzugsweise in eine zur Abstützung eines Magazins bestimmten Transportfläche einer Bearbeitungs- bzw. Behandlungsstation der Linie von Maschinen bzw. Einrichtungen eine gegebenenfalls als Stufe ausgebildete Ausnehmung zur Aufnahme der Nase eingeformt ist. Die Nasen übergreifen dann in jedem Fall auch den untersten Systemträger, so dass auch dieser gesichert im Magazin transportiert werden kann. Beispielsweise wird das Magazin zum Aufsetzen an einer Ladeposition zunächst über der Stufe herangefahren und dann auf die Transportfläche bzw. den Transportriemen abgesetzt, wobei die Nase die Stufe hintergreift. Entsprechendes erfolgt in entgegengesetzer Reihenfolge und Richtung an einer Entladeposition.

Durch den Angriff des Magazins von der Seite her kann dieses eine beliebige Breite, Höhe oder Länge haben. Die Länge des Magazins wird lediglich von dem maximalen Abstand der Klemmbacken voneinander begrenzt.

Zur möglichst weitgehenden Gewichtsreduzierung sollte die Klemmbacke möglichst schlank ausgebildet sein, aber über die gesamte Höhe des Magazins eine möglichst gleichbleibende Klemmwirkung ausüben. Dies kann dadurch gewährleistet werden, dass die Klemmbacken in eine untere Leiste und einen oberen Leistenstreifen aufgeteilt sind, wobei zwischen Leiste und Leistenstreifen eine Auflageschulter ausgeformt ist. Diese Auflageschulter liegt in Gebrauchslage der oberen Kante der oben erwähnten Stützleiste des Greifadapters auf, so dass sich der obere Leistenstreifen, der im Gegensatz zur unteren Leiste kein Widerlager besitzt, über diese Auflageschulter gegen die Stützleiste abstützen kann.

Zu diesem Zweck ist daher die Greifeinrichtung vorzugsweise mit zwei Greifadaptern versehen, die je einer Klemmbacke zugeordnet und mit je einer Stützleiste zur Abstütztung und Befestigung der entsprechenden Klemmbacke versehen sind. Dabei weist die Klemmbacke vorzugsweise eine an der Stützleiste des Greifadapters abgestützte und befestigte Klemmbackenleiste sowie eine die Stützleiste übergreifende und daran abgestützte Auflageschulter eines die Stützleiste überragenden Seitenstreifens auf, während die Stützleiste vorzugsweise als aus einer Tragfläche des Greifadapters herausragender Vorsprung ausgebildet ist.

In einem bevorzugten Ausführungsbeispiel der Erfindung ist die Klemmbacke an der Stützleiste federnd gelagert. Durch diese federnde Lagerung wird einer Änderung der Abmessungen des Magazins beispielsweise beim Abkühlen desselben nach einer Behandlung in einem Ofen Rechnung getragen. Auch einer Ungenauigkeit des Magazins wird dadurch Rechnung getragen, beispielsweise wenn eine Magazinkante eine Schräge aufweist.

Um dennoch einen beliebig gewünschten Anpressdruck der Klemmbacken auf die Seitenkanten der von der Greifereinrichtung gefassten Wand des Magazins zu gewährleisten, kann vorzugsweise vorgesehen werden, dass ein an der Stützleiste zwischen zwei Federelementen ortsfest angeordneter Bolzen in einen in der Klemmbacke vorgesehenen Ausschnitt eingreift und darin gegen Federkräfte der Federelemente bewegbar ist, wobei ein Grund des Ausschnitts so an der Klemmbacke und der Bolzen so an der Stützleiste positioniert ist, dass zwischen der Klemmbacke und der Stützleiste auch dann ein Abstand vorhanden ist, wenn der Bolzen gegen die Federkräfte der Federelemente bis an den Grund des Ausschnitts angedrückt ist. Durch diese Massnahme bildet der Bolzen einen Drehpunkt für eine Wippenbewegung der Klemmbacke an der Stützleiste. Beim Anpressen der Klemmbacken auf die Seitenkanten der Wand des Magazins wippen zunächst die Klemmbacken gegen die Federkräfte der Federelemente, bis sie an den Seitenkanten satt anliegen, dann wird der Bolzen im Ausschnitt der Klemmbacke gegen die Federkräfte beim Zusammendrücken der Federelemente bewegt, bis er am Grund des Ausschnitts anliegt, danach aber verhindert der Kontakt des Bolzens mit dem Grund des Ausschnitts jedes weitere Nachgeben der Klemmbacken, d.h. die volle Kraft der Greifereinrichtung kann dann zum Fassen des Magazins wirken.

Im übrigen weisen vorzugsweise die Greifeinrichtung eine Frontfläche einer Abdeckplatte und die beiden Greifadapter je eine Tragfläche auf, während die Frontfläche und die beiden Tragflächen im wesentlichen in einer Ebene liegen, und die Frontfläche sowie im wesentlichen auch die Tragflächen in Richtung orthogonal zur eingeklemmten Wand an dieser anliegen, wenn das Magazin von der Greifeinrichtung gefasst ist.

Diese Abdeckplatte schützt ein weiter unten erwähntes Getriebe und dient gleichzeitig als Anschlag der Greifeinrichtung an der Wand des Magazins, so dass diese Frontfläche der Abdeckplatte eine Referenzfläche beim Zugreifen des Transportroboters bildet und nötigenfalls auch dazu dient, das Magazin zurechtzurücken.

Vorzugsweise sind die beiden Greifadapter beiderseits der Abdeckplatte an gegenläufig drehbaren Spindel antrieben geführt, die ihrerseits vorzugsweise mit einem Getriebe verbunden sind, welchem seinerseits ein Antrieb zugeordnet ist.

Dies hat den Vorteil, dass wenn beispielsweise das Magazin in eine Entladeposition kommen sollte, welche von der Ladeposition abweicht, nun mittels der Frontfläche der Abdeckplatte als Referenzfläche und den seitlich geführten Greifadaptern eine Korrektur der Position des Magazins vorgenommen werden kann. Hierdurch können sich Positionierfehler des Transportroboters nicht in den einzelnen Bearbeitungs-bzw. Behandlungsstation addieren.

Ein weiterer Vorteil der Kombination von Spindelantrieben und Getriebe ist, dass die Klemmkraft auch bei einem Stromausfall nicht aufgehoben wird und deshalb das Magazin auch bei einem Stromausfall nicht aus der Greifeinrichtung fallen kann. Ferner erfolgt die Klemmung des Magazins mit einer definierten Klemmkraft ohne Verkanten der Klemmbacken.

Für den Antrieb wird beispielsweise ein symmetrischer kraftgesteuerter Gleichstrom-Motor gewählt.

Vorzugsweise ist die Greifeinrichtung über einen Tragarm mit darin integrierter Gewindehülse an einer senkrecht in einem Säulenprofil des Transportroboters angeordneten Spindel abgestützt. Diese Anordnung ermöglicht eine Hubbewegung der Greifeinrichtung, die vor allem notwendig ist, um unterschiedliche Höhen der betreffenden Maschinen bzw. Einrichtungen zur automatischen Bearbeitung bzw. Behandlung von elektronischen Bauelementen auszugleichen, beispielsweise um in unterschiedlichen Höhen angeordnete Aushärtungsöfen waagrecht bedienen zu können.

Insgesamt ist der erfindungsgemässe Transportroboter mit Vorteil zum Transport eines Magazins mit darin eingesetzten Systemträgern (sogenannten Leadframes) für elektronische Bauelemente (sogenannte Chips) in einer Linie von Maschinen bzw. Einrichtungen zur automatischen Bearbeitung bzw. Behandlung dieser elektronischen Bauelemente verwendbar.

Eine solche Verwendung ist preisgünstig, wobei die Umrüstung von vorhandenen Transportrobotern lediglich bezüglich der Greifeinrichtung mechanisch, ansonsten nur softwaremässig zu erfolgen braucht.

Weitere Vorteile, Merkmale und Einzelheiten der Erfindung ergeben sich aus der nachfolgenden Beschreibung bevorzugter Ausführungsbeispiele sowie anhand der Zeichnung. Es zeigen:
- Fig. 1: eine perspektivische Ansicht einer Linie von Maschinen bzw. Einrichtungen zur automatischen Bearbeitung bzw. Behandlung von elektronischen Bauelementen;
- Fig. 2: eine schematisierte Draufsicht auf einen erfindungsgemässen Transportroboter;
- Fig. 3: eine Seitenansicht des Transportroboters gemäss Fig. 2;
- Fig. 4: eine Seitenansicht eines Teils einer Bearbeitungs-bzw. Behandlungsstation sowie eines Teils des Transportroboters gemäss Fig. 2 beim Aufsetzen eines Magazins;
- Fig. 5: eine Seitenansicht eines Teils eines weiteren Ausführungsbeispiels eines Transportroboters;
- Fig. 6: eine Vorderansicht des Teils des Transportroboters beim Ausführungsbeispiel gemäss Fig. 5;
- Fig. 7: eine Draufsicht auf eine erfindungsgemässe Klemmbacke;
- Fig. 8: eine weitere Draufsicht auf die Klemmbacke gemäss Fig. 5, jedoch um 90° gedreht.

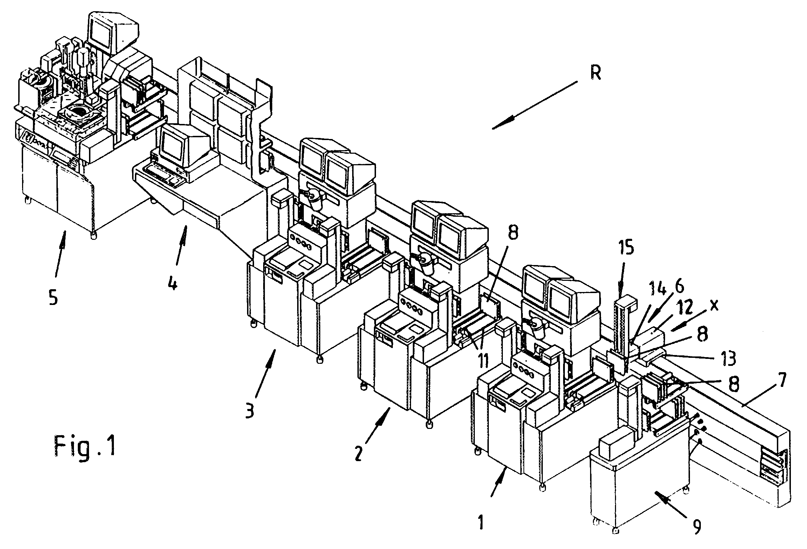

Eine Linie R von Maschinen bzw. Einrichtungen zur automatischen Bearbeitung bzw. Behandlung von elektronischen Bauelementen (sogenannten Chips) weist in Reihe hintereinander geschaltet mehrere Bearbeitungs- bzw. Behandlungsstationen auf (vgl. Fig. 1). In der Linie R werden Systemträger (sogenannte Leadframes) von Station zu Station transportiert, um dort bearbeitet bzw. behandelt zu werden. Beispielsweise sind in der Linie R eine Einrichtung 5 (sogenannter Die Bonder) zur Befestigung der elektronischen Bauelemente auf dem Systemträger, vier gleichartige Einrichtungen 4 zur Aushärtung von Klebstoffen (sogenannte Curing-öfen) und drei gleichartige Einrichtungen 1, 2, 3 zur Drahtkontaktierung (sogenannte Wire Bonder) in Reihe hintereinander geschaltet angeordnet.

Über einen Transportroboter 6, welcher auf einer Schiene 7 verfahrbar ist, werden Magazine 8, die mit Systemträgern bestückt sind, einem Puffer 9 entnommen und zu den entsprechenden Bearbeitungs- bzw. Behandlungsstationen transportiert. Anders als beim bisher bekannten Stand der Technik ist dabei die Schiene 7 mit dem Transportroboter 6 hinter der jeweiligen Bearbeitungs- bzw. Behandlungsstation positioniert, so dass eine Bearbeitung der entsprechenden systemträger von vorne ohne Schwierigkeiten stattfinden kann.

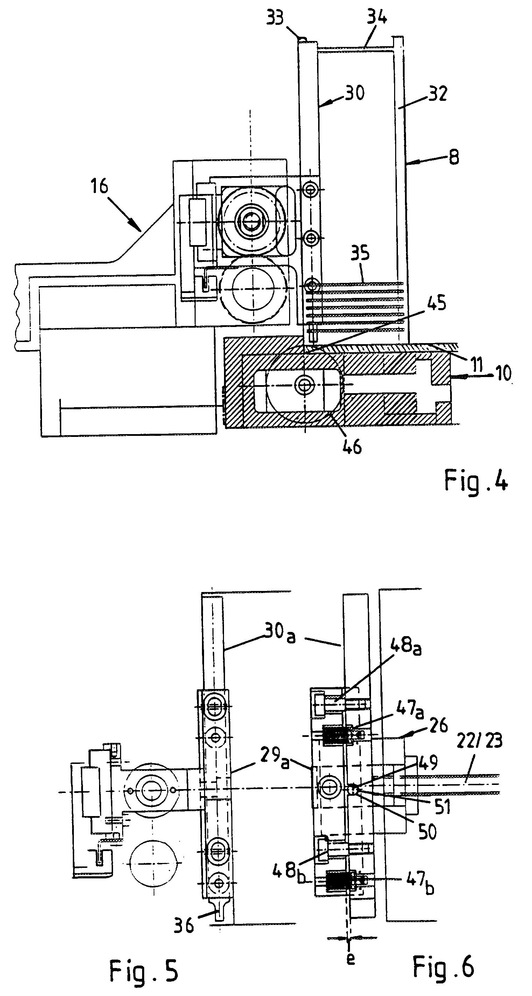

Der Transportroboter 6 setzt ein Magazin 8 auf eine Transportfläche 10 einer Bearbeitungs- bzw. Behandlungsstation auf, wobei sich in der Transportfläche 10 entsprechende Transportbänder 11 befinden, welche eine gegebenenfalls angetriebene Umlenkrolle 46 umschlingen. In Fig. 4 ist erkennbar, dass in der Transportfläche 10 eine Stufe 45 eingeformt ist, über welche hinweg das Magazin 8 auf die Transportbänder 11 aufgesetzt wird. Mittels der Transportbänder 11 wird das Magazin 8 zur Vorderseite der Bearbeitungs- bzw. Behandlungsstation transportiert. Dort werden die Systemträger 35 aus dem Magazin 8 entnommen, bearbeitet bzw. behandelt und dann wieder in das Magazin 8 zurückgegeben. Danach erfolgt mittels der Transportbänder 11 ein Rücktransport des Magazins 8, bis es durch Reibung an den laufenden Transportbändern 11 gegen die Stufe 45 gedrückt wird, welche dadurch als Anschlag für das Magazin 8 wirkt. In dieser Position des Magazins 8 kann es von dem Transportroboter 6 erfasst und zu einer anderen Bearbeitungs- bzw. Behandlungsstation weitergegeben werden, um beispielsweise nacheinander die Einrichtung 5 (sogenannter Die Bonder) zur Befestigung der elektronischen Bauelemente auf dem Systemträger, eine Einrichtung 4 zur Aushärtung von Klebstoffen (sogenannte Curing-Öfen) und eine Einrichtung 1, 2 oder 3 zur Drahtkontaktierung (sogenannte Wire Bonder) durchzulaufen.

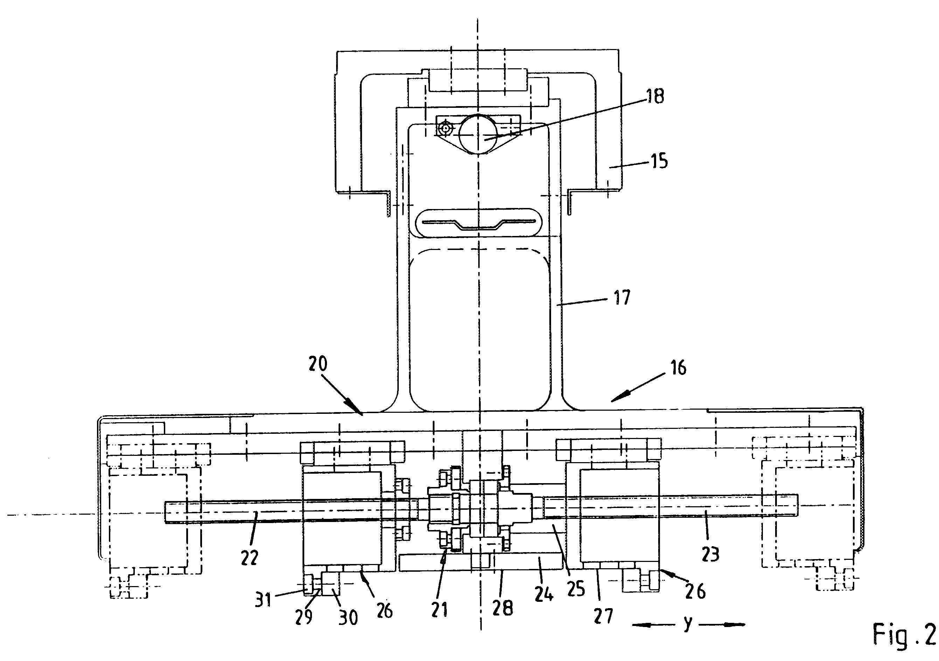

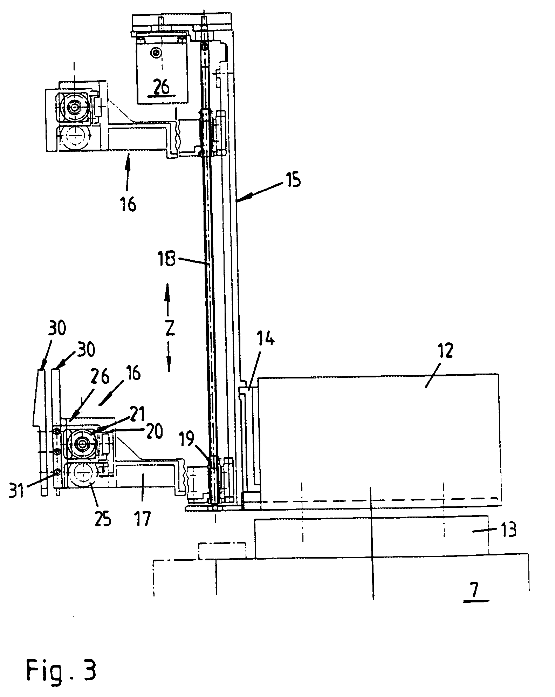

Der Transportroboter 6 sitzt mit einem Gehäuse 12 einem Schlitten 13 auf, wobei der Schlitten 13 auf der Schiene 7 verfahrbar angeordnet ist. Aus dem Gehäuse 12 ist ein Teleskoprahmen 14 in Richtung X ausfahrbar, so dass ein Säulenprofil 15 mit einer insbesondere in den Fig. 2 und 3 gezeigten Greifeinrichtung 16 nahe an ein Magazin 8 herangebracht werden kann.

Dabei weist die Greifeinrichtung 16 einen Tragarm 17 auf, welcher in dem Säulenprofil 15 an einer Spindel 18 geführt ist. Auf die Spindel 18 ist eine Gewindehülse 19 aufgesetzt, deren Innengewinde mit dem Aussengewinde der Spindel 18 zusammenwirkt. Hierdurch erfolgt ein Anheben oder Absenken des Tragarmes 17 und damit der Greifeinrichtung 16 in Richtung des Doppelpfeiles Z.

An den Tragarm 17 ist ein Schienenstreifen 20 angeflanscht, an welchem ein Getriebe 21 zum Drehen von zwei spiegelbildlich angeordneten Spindelstangen 22 und 23 festgelegt ist. Frontwärtig wird das Getriebe 21 von einer Abdeckplatte 24 abgedeckt. Dem Getriebe 21 ist im übrigen ein Antrieb 25 zugeordnet, der in Fig. 2 unterhalb des Getriebes 21 angedeutet ist, wobei entsprechende Getriebelemente eine Drehung einer Antriebswelle auf das Getriebe übertragen und das Getriebe 21 diese Drehung in eine Drehung der Spindelstangen 22 und 23 umsetzt. Es versteht sich von selbst, dass auch der Spindel 18 ein entsprechender Antrieb 26 zugeordnet ist, durch den die Spindel 18 gedreht wird, wobei sich dann die Gewindehülse 19 und mit ihr der Tragarm 17 bzw. die Greifeinrichtung 16 in Richtung des Doppelpfeiles Z bewegen.

Auf jeder Spindelstange 22 und 23 befindet sich ein Greifadapter 26, welcher sowohl an den Spindelstangen 22 und 23 wie auch an dem Schienenstreifen 20 geführt ist. Bei Drehung der Spindelstangen 22 und 23, welche gegenläufig erfolgt, wird jeder Greifadapter 26 in Richtung des Doppelpfeiles Y bewegt. Die Spindelstangen 22 und 23 bilden also mit den Greifadaptern 26 zwei gegenläufige Spindelantriebe. Eine äussere Endlage des Greifadapters 26 ist gestrichelt bzw. strichpunktiert angedeutet.

Eine Frontfläche 27 des Greifadapters 26 liegt in einer Ebene einer Frontfläche 28 der Abdeckplatte 24. Über diese Frontfläche 27 hinausragend sind den Adaptern 26 jeweils seitlich Stützleisten 29 angeformt, welche Klemmbacken 30 halten. Die Klemmbacken 30 sind dabei über entsprechende Schrauben 31 mit den Stützleisten 29 verbunden.

In Fig. 4 ist die Tätigkeit der Greifeinrichtung 16 deutlich gezeigt. Die Magazine 8 bestehen in der Regel aus einer Frontwand 32 und einer Rückwand 33. Beide Wände 32 und 33 sind über Gewindebolzen 34 parallel zueinander und im Abstand voneinander gehalten, wobei den Gewindebolzen 34 beispielsweise Abstandshülsen zwischen beiden Wänden 32 und 33 aufgesetzt sein können. Zwischen Frontwand 32 und Rückwand 33 sind Systemträger 35 angeordnet, die beispielsweise in entsprechenden Fächern oder Nuten aufgenommen sein können.

Das Magazin 8 wird zum Transport von der Greifeinrichtung 16 so angegriffen und gefasst, dass die Klemmbacken 30 die Rückwand 33 von beiden Seiten her zwischen sich aufnehmen und klemmend halten.

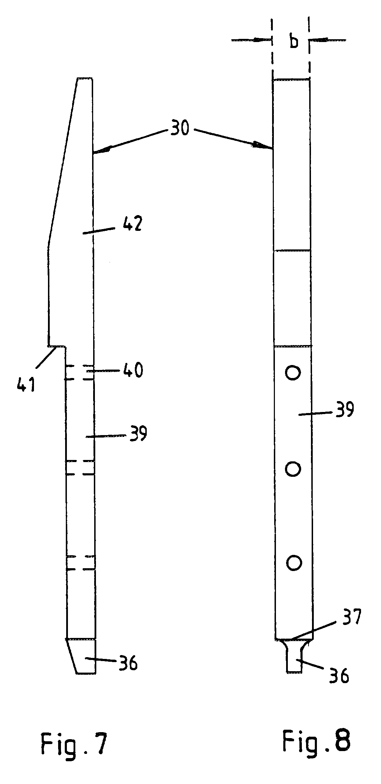

Dabei weist jede Klemmbacke 30 gemäss den Fig. 5 und 8 eine Breite b auf, welche etwas grösser ist, als die Breite b₁ der Rückwand 33. Dies gewährleistet, dass die Klemmbacke 30 mit einem Teil ihrer Breite b in die lichte Weite zwischen Frontwand 32 und Rückwand 33 einragt, so dass ein Herausfallen der Systemträger 35 aus dem Magazin 8 beim Transport vermieden wird. Eben diesem Zweck dient auch eine Nase 36, welche einem unteren Rand 37 der Klemmbacke 30 angeformt ist. Diese Nase 36 dient einem Ausgleich, wenn beispielsweise die Greifeinrichtung 16 zu hoch an dem Magazin 8 angesetzt wird. Wäre die Nase 36 nicht vorhanden, bestünde die Gefahr, dass bei einem zu hohen Ansetzen der Klemmbacken 30 an den Seitenkanten der Rückwand 33 die untersten Systemträger frei wären und aus dem Magazin 8 herausgleiten könnten. Dies wird durch die Nase 36 verhindert, welche mit ihrer Breite ebenfalls zumindest teilweise in die lichte Weite zwischen Frontwand 32 und Rückwand 33 einragt.

Damit jedoch überhaupt ein ordnungsgemässer Angriff der Greifeinrichtung 16 an dem Magazin 8 auf der Transportfläche 10 möglich ist, ist dieser Transportfläche 10 jeweils beiderseits eine beispielsweise als Stufe 45 ausgebildete Ausnehmung eingeformt, welche von der Nase 36 sowohl beim Abstellen des Magazins 8 wie auch bei dessen Aufnahme hintergriffen wird.

An die Nase 36 schliesst sich nach oben eine Leiste 39 an, welche zur Anlage an die Stützleiste 29 dient. In dieser Leiste 39 sind auch Bohrungen 40 für die Schrauben 31 vorgesehen.

Im Anschluss an die Leiste 39 ist die Klemmbacke unter Ausbildung einer Auflageschulter 41 zu einem freien Leistenstreifen 42 verbreitet, wobei diese nach oben konisch zuläuft. Die Auflageschulter 41 schlägt in Gebrauchslage auf der Oberkante der Stützleiste 29 auf, wodurch der Leistenstreifen 42 abgestützt ist. Deshalb kann dieser bei einer klemmenden Anlage der Klemmbacke 30 an das Magazin 8 nicht nach aussen ausweichen. Hierdurch wird das Magazin 8 gesichert gehalten.

In einem in Fig. 5 und 6 näher dargestellten Ausführungsbeispiel der Erfindung sind die Klemmbacken federnd ausgebildet. Eine entsprechende Klemmbacke 30a nimmt dabei von einer entsprechenden Stützleiste 29a gegen die Federkraft von zwei Federelementen 47a und 47b einen variablen Abstand e ein. Die Federelemente 47a und 47b bestehen beispielsweise aus Paketen von Scheibenfedern, d.h. sogenannten Federpaketen. Dadurch kann Änderungen und Ungenauigkeiten der Abmes-sungen des Magazins durch Abfederung der Klemmbacke 30a Rechnung getragen werden.

Ein Bolzen 49 ist an der Stützleiste 29a zwischen den beiden Federelementen 47a und 47b ortsfest angeordnet, während an der Klemmbacke 30a ein Ausschnitt 50 vorgesehen ist, in den der Bolzen 49 eingreift, wobei er darin gegen Federkräfte der Federelemente bewegbar ist. Der Ausschnitt 50 weist einen Grund 51 auf, bis zum dem der Bolzen 49 gegen die Federkraft der beiden Federelemente 47a und 47b gedrückt werden kann. Der Grund 51 des Ausschnitts 50 ist so an der Klemmbacke 30a und der Bolzen 49 so an der Stützleiste 29a positioniert, dass zwischen der Klemmbacke 30a und der Stützleiste 29a auch dann ein in Fig. 6 eingezeichneter durchschnittlicher Abstand e eingehalten wird, wenn der Bolzen 49 gegen die Federkraft der beiden Federelemente 47a und 47b bis an den Grund 51 des Ausschnitts 50 angedrückt wird. Dadurch bildet der Bolzen 49 einen Drehpunkt für eine Wippenbewegung der Klemmbacke 30a an der Stützleiste 29a, die dazu beiträgt, den Änderungen und Ungenauigkeiten der Abmessungen des Magazins Rechnung zu tragen. Beim Anpressen der beiden Klemmbacken 30a beiderseits auf die Seitenkanten der Wand des Magazins wippen zunächst die Klemmbacken 30a gegen die Federkräfte der Federelemente 47a und 47b, bis sie an den Seitenkanten des Magazins satt anliegen. Anschliessend wird der Bolzen im Ausschnitt 50 gegen die Federkräfte beim weiteren Zusammendrücken der Federelemente 47a und 47b bewegt, bis er am Grund 51 des Ausschnitts 50 anliegt. Danach aber verhindert der Kontakt des Bolzens 49 mit dem Grund 51 des Ausschnitts 50 jedes weitere Nachgeben der Klemmbacken 30a, so dass die volle Kraft der Greifereinrichtung auf die Klemmbacken 30a übertragen wird und zum Fassen des Magazins wirkt.

Wesentlicher Vorteil dieser Massnahme ist, dass beispielsweise bei Aufnahme des Magazins 8 aus einem Ofen einem Zusammenziehen des Magazins 8 Rechnung getragen wird. Aus diesem Grund liegt der Bolzen 49 in Ruhelage eben nicht am Grund 51 des Ausschnitts 50, sondern im Abstand von beispielsweise zwei Millimetern davon. Bei Aufnahme des Magazins 8 wird zuerst dieser Ruhelage-Abstand bis auf Null vermindert. Kühlt das Magazin 8 ab, so fällt es nicht zwischen den beiden Klemmbacken 30a herab, weil diese dank der Zurückfederung der Federelemente 47a und 47b den Änderungen der Dimensionen des Magazins 8 folgen.

## Patentansprüche

1. Transportroboter zum Transport eines im wesentlichen quaderförmigen Magazins (8) für mit elektronischen Bauelementen (sogenannten Chips) bestückte Systemträger (35) (sogenannte Leadframes) in einer Linie von Maschinen bzw. Einrichtungen zur automatischen Bearbeitung bzw. Behandlung dieser elektronischen Bauelemente, wobei das Magazin im wesentlichen aus zwei einander parallelen und im Abstand voneinander gehaltenen Wänden (32, 33) besteht und mit mindestens einem in Fächern oder Nuten seiner Wände (32, 33) eingesetzten Systemträgern (35) bestückt ist, und wobei der Transportroboter mit einer Greifeinrichtung (16) zum automatischen Fassen und Loslassen des Magazins (8) versehen ist, **dadurch gekennzeichnet**, dass die Greifeinrichtung (16) zwei Klemmbacken (30; 30a) aufweist, die an je einer Seitenkante einer Wand (33) des Magazins (8) anliegen und zusammen diese Wand (33) einklemmen, wenn das Magazin (8) von der Greifeinrichtung (16) gefasst ist, wobei in Richtung orthogonal zu dieser eingeklemmten Wand (33) eine Breite (b) der Klemmbacken (30; 30a) grösser ist als die Dicke (b₁) dieser Wand (33), wobei die Klemmbacken beiderseits in die lichte Weite des Magazins einragen, so dass die Systemträger seitlich nicht mehr aus dem Magazin herausgleiten können.

2. Transportroboter nach Anspruch 1, dadurch gekennzeichnet, dass einander zugewandte Seiten der beiden Klemmbacken (30; 30a) im wesentlichen in einander parallelen Ebenen liegen, welche ihrerseits orthogonal zur eingeklemmten Wand (33) liegen.

3. Transportroboter nach Anspruch 2, dadurch gekennzeichnet, dass die Greifeinrichtung (16) mit zwei Greifadaptern (26) versehen ist, die je einer Klemmbacke (30; 30a) zugeordnet und mit je einer Stützleiste (29) zur Abstützung und Befestigung der entsprechenden Klemmbacke (30; 30a) versehen sind.

4. Transportroboter nach Anspruch 3, dadurch gekennzeichnet, dass die Klemmbacke (30a) an der Stützleiste (29a) federnd gelagert ist.

5. Transportroboter nach Anspruch 4, dadurch gekennzeichnet, dass ein an der Stützleiste (29a) zwischen zwei Federelementen (47a, 47b) ortsfest angeordneter Bolzen (49) in einen in der Klemmbacke (30a) vorgesehenen Ausschnitt (50) eingreift und darin gegen Federkräfte der Federelemente (47a, 47b) bewegbar ist, wobei ein Grund (51) des Ausschnitts (50) an der Klemmbacke (30a) und der Bolzen (49) an der Stützleiste (29a) so positioniert ist, dass zwischen der Klemmbacke (30a) und der Stützleiste (29a) auch dann ein Abstand (e) vorhanden ist, wenn der Bolzen (49) gegen die Federkräfte der Federelemente (47a, 47b) bis an den Grund (51) des Ausschnitts (50) angedrückt ist.

6. Transportroboter nach Anspruch 2, dadurch gekennzeichnet, dass an einem unteren Rand (37) jeder Klemmbacke (30; 30a) eine Nase (36) angeformt ist, deren der anderen Nase (36) zugewandte Seite in derselben Ebene liegt wie die entsprechende Ebene der Klemmbacke (30; 30a) selbst.

7. Transportroboter nach Anspruch 3, dadurch gekennzeichnet, dass die Greifeinrichtung (16) eine Frontfläche (28) einer Abdeckplatte (24) und die beiden Greifadapter (26) je eine Tragfläche (27) aufweisen, die Frontfläche (28) und die beiden Tragflächen (27) im wesentlichen in einer Ebene liegen, und die Frontfläche (28) sowie im wesentlichen auch die Tragflächen (27) in Richtung orthogonal zur eingeklemmten Wand (33) an dieser Wand (33) anliegen, wenn das Magazin (8) von der Greifeinrichtung (16) gefasst ist.

8. Transportroboter nach Anspruch 3, dadurch gekennzeichnet, dass die Klemmbacke (30) eine an der Stützleiste (29) des Greifadapters (26) abgestützte und befestigte Klemmbackenleiste (39) sowie eine die Stützleiste (29) übergreifende und daran abgestützte Auflageschulter (41) eines die Stützleiste (29) überragenden Seitenstreifens (42) aufweist.

9. Transportroboter nach Anspruch 3, dadurch gekennzeichnet, dass die Stützleiste (29) als aus einer Tragfläche (27) des Greifadapters (26) herausragender Vorsprung ausgebildet ist.

10. Transportroboter nach Anspruch 3, dadurch gekennzeichnet, dass die beiden Greifadapter (26) beiderseits der Abdeckplatte (24) an gegenläufig drehbaren Spindelantrieben (22, 23) geführt sind.

11. Transportroboter nach Anspruch 8, dadurch gekennzeichnet, dass die Spindelantriebe (22, 23) mit einem Getriebe (21) verbunden sind, welchem seinerseits ein Antrieb (25) zugeordnet ist.

12. Transportroboter nach Anspruch 1, dadurch gekennzeichnet, dass die Greifeinrichtung (16) über einen Tragarm (17) mit darin integrierter Gewindehülse (19) an einer senkrecht in einem Säulenprofil (15) des Transportroboters (6) angeordneten Spindel (18) abgestützt ist.

## Claims

1. Transport robot for transporting an essentially cuboidal magazine (8) for lead frames (35) fitted with electronic chips in a line of machines or devices for the automatic processing or treatment of these electronic chips, the magazine essentially comprising two walls (32, 33) kept parallel to each other and at a distance from each other and being fitted with at least one lead frame (35) inserted in compartments or grooves of its walls (32, 33), and the transport robot being provided with a gripping device (16) for the automatic grasping and releasing of the magazine (8), characterized in that the gripping device (16) has two clamping jaws (30; 30a) which bear against one side edge each of a wall (33) of the magazine (8) and together clamp this wall (33) when the magazine (8) is grasped by the gripping device (16), a width (b) of the clamping jaws (30; 30a) in a direction orthogonal to this clamped-in wall (33) being greater than the thickness (b₁) of this wall (33), the clamping jaws on both sides protruding into the clear widths of the magazine, so that the lead frames can no longer slide out laterally from the magazine.

2. Transport robot according to Claim 1, characterized in that mutually facing sides of the two clamping jaws (30; 30a) lie essentially in planes parallel to each other, which for their part lie orthogonally to the clamped-in wall (33).

3. Transport robot according to Claim 2, characterized in that the gripping device (16) is provided with two gripping adapters (26), which are each assigned to a clamping jaw (30; 30a) and are provided with a supporting bar (29) each for supporting and fastening the corresponding clamping jaw (30; 30a).

4. Transport robot according to Claim 3, characterized in that the clamping jaw (30a) is mounted resiliently on the supporting bar (29a).

5. Transport robot according to Claim 4, characterized in that a bolt (49) arranged fixedly on the supporting bar (29a) between two spring elements (47a, 47b) engages in a cutout (50) provided in the clamping jaw (30a) and can be moved therein against spring forces of the spring elements (47a, 47b), a base (51) of the cutout (50) being positioned at the clamping jaw (30a) and the bolt (49) being positioned at the supporting bar (29a) in such a way that there is a distance (e) between the clamping jaw (30a) and the supporting bar (29a) even when the bolt (49) is pressed against the spring forces of the spring elements (47a, 47b) up to the base (51) of the cutout (50).

6. Transport robot according to Claim 2, characterized in that there is formed on a lower rim (37) of each clamping jaw (30; 30a) a lug (36), whose side facing the other lug (36) lies in the same plane as the corresponding plane of the clamping jaw (30; 30a) itself.

7. Transport robot according to Claim 3, characterized in that the gripping device (16) has a front surface (28) of a covering plate (24) and the two gripping adapters (26) each have a bearing surface (27), the front surface (28) and the two bearing surfaces (27) lie essentially in one plane, and the front surface (28) and also essentially the bearing surfaces (27) bear against the clamped-in wall (33) in a direction orthogonal to this wall (33) when the magazine (8) is grasped by the gripping device (16).

8. Transport robot according to Claim 3, characterized in that the clamping jaw (30) has a clamping jaw bar (39), supported and fastened on the supporting bar (29) of the gripping adapter (26), and also a rest shoulder (41), engaging over the supporting bar (29) and supported thereon, of a side strip (42) rising above the supporting bar (29).

9. Transport robot according to Claim 3, characterized in that the supporting bar (29) is designed as a projection rising out from a bearing surface (27) of the gripping adapter (26).

10. Transport robot according to Claim 3, characterized in that the two gripping adapters (26) on both sides of the covering plate (24) are guided on oppositely rotatable spindle drives (22, 23).

11. Transport robot according to Claim 8, characterized in that the spindle drives (22, 23) are connected to a gear mechanism (21), which for its part is assigned a drive (25).

12. Transport robot according to Claim 1, characterized in that the gripping device (16) is supported by means of a bearing arm (17) with a threaded sleeve (19) integrated therein on a spindle (18) arranged perpendicularly in a column profile (15) of the transport robot (6).

## Revendications

1. Robot de transport pour le transport d'un magasin (8) essentiellement quadrilatère pour des porte-systèmes (35) (dits "Leadframes") équipés de composants électroniques (dits puces) dans une ligne de machines respectivement de dispostifs pour le traitement respectivement la transformation de ces composants électroniques, le magasin se composant essentiellement de deux parois (32, 33) parallèles entre elles et maintenues à distance l'une de l'autre et étant au moins équipés d'un porte-systèmes (35) inséré dans des cases ou rainures de ses parois (32, 33) et le robot de transport étant muni d'un dispositif de préhension (16) pour la saisie et la libération automatique du magasin (8), caractérisé en ce que le dispositif de préhension (16) présente deux mâchoires de serrage (30 ; 30a) qui s'appliquent chacune sur un bord latéral d'une paroi (33) du magasin (8) et serrent ensemble cette paroi (33) quand le magasin (8) est saisi par le dispositif de préhension (16), une largeur (b) des mâchoires de serrage (30 ; 30a) étant supérieure à l'épaisseur de cette paroi (33) dans la direction orthogonale de cette paroi serrée (33), les mâchoires de serrage s'engageant, des deux côtés, dans la largeur intérieure du magasin si bien que les porte-systèmes ne peuvent plus s'échapper du magasin en glissant latéralement.

2. Robot de transport selon la revendication 1, caractérisé en ce que les faces mutuellement opposées des deux mâchoires de serrage (30 ; 30a) se trouvent sensiblement dans des plans parallèles entre eux qui, quant à eux, sont orthogonaux par rapport à la paroi serrée (33).

3. Robot de transport selon la revendication 2, caractérisé en ce que le dispositif de préhension (16) est donc muni, de préférence, de deux adaptateurs de pince (26) qui sont associés chacun à une mâchoire de serrage (30 ; 30a) et qui sont munis d'une baguette de support (29) pour le soutien et la fixation de la mâchoire de serrage (30 ; 30a) correspondante.

4. Robot de transport selon la revendication 3, caractérisé en ce que la mâchoire de serrage (30a) est logée de manière élastique sur la baguette de support (29a).

5. Robot de transport selon la revendication 4, caractérisé en ce qu'un boulon (49), disposé fixement sur la baguette de support (29a) entre deux éléments formant ressort (47a, 47b), s'engage dans une découpe (50), prévue dans la mâchoire de serrage (30a), et est mobile, à l'intérieur, à l'encontre de la force des éléments formant ressort (47a, 47b), un fond (51) de la découpe (50) étant positionné contre la mâchoire de serrage (30a) et le boulon (49) étant positionné contre la baguette de support (29a) de manière qu'entre la mâchoire de serrage (30a) et la baguette de support (29a), il existe également un intervalle (e) quand le boulon (49) est pressé, à l'encontre de la force des éléments formant ressort (47a, 47b), tout au fond (51) de la découpe (50).

6. Robot de transport selon la revendication 2, caarctérisé en ce qu'il est moulé, sur le bord inférieur (37), de chaque mâchoire de serrage (30 ; 30a), une came (36) dont la face, tournée vers l'autre came (36), se trouve dans le même plan que le plan correspondant de la mâchoire de serrage (30 ; 30a), elle-même.

7. Robot de transport selon la revendication 3, caractérisé en ce que le dispositif de préhension (16) présente une surface frontale (28) d'une plaque de recouvrement (24) et les deux adaptateurs de pince (26) présentent une surface porteuse (27), tandis que la surface frontale (28) et les deux surfaces porteuses (27) se trouvent sensiblement dans le même plan et la surface frontale (28) ainsi que sensiblement les surfaces porteuses (27) s'appliquent de manière orthogonale par rapport à la paroi (33), contre cette paroi serrée (33) quand le magasin (8) est saisi par le dispositif de préhension (16).

8. Robot de transport selon la revencication 3, caractérisé en ce que la mâchoire de serrage (30) présente une baguette de mâchoire de serrage (39), fixée et soutenue sur la baguette de support (29) de l'adaptateur de pince (26), ainsi qu'un épaulement d'appui (41) qui, en prenant appui dessus, recouvre la baguette de support (29) d'une bande latérale (42) recouvrant la baguette de support (29).

9. Robot de transport selon la revendication 3, caractérisé en ce que la baguette de support (29) est conçue comme une avancée faisant saillie de la surface porteuse (27) de l'adaptateur de pince (26).

10. Robot de transport selon la revendication 3, caractérisé en ce que les deux adaptateurs de pinces (26) sont guidés, des deux côtés de la plaque de recouvrement (24), le long de commandes de broche (22, 23) rotatives en sens contraire.

11. Robot de transport selon la revendication 8, caractérisé en ce que les commandes de broche (22, 23) sont reliées à une transmission (21) qui, quant à elle, est associée à un entraînement (25).

12. Robot de transport selon la revendication 1, caractérisé en ce que le dispositif de préhension (16) prend appui, par l'intermédiaire d'un bras support (17), présentant une douille filetée intégrée (19), contre une broche (18) disposée verticalement dans une colonne profilée (15) du robot de transport (6).
